# EUROPÄISCHE PATENTANMELDUNG

(11) **EP 4 203 630 A1**
(43) Veröffentlichungstag der Anmeldung: **28.06.2023**
(21) Anmeldenummer: 22215455.1
(22) Anmeldetag: 21.12.2022
(51) Int. Cl.: H05K 3/00, H05K 3/46, H05K 3/40

(54) **VERFAHREN SOWIE VORRICHTUNG ZUM HERSTELLEN EINER MEHRLAGIGEN LEITERPLATTE (PCB)**

(30) Priorität: 23.12.2021 DE 102021134575
(71) Anmelder: Embedded Expert Designers UG (Haftungsbeschränkt), 92224 Amberg (DE)
(72) Erfinder: Medic, Marko, 92224 Amberg (DE)
(74) Vertreter: Canzler & Bergmeier Patentanwälte Partnerschaft mbB

(57) **Zusammenfassung**

Vorgeschlagen wird ein Verfahren zum Herstellen einer mehrlagigen Leiterplatte (PCB) (7). Bei dem erfindungsgemäßen Verfahren wird zunächst eine dielektrische Schicht (1) bereitgestellt. Anschließend wird mittels eines Druckverfahrens eine Leiteranordnung (2) auf der dielektrischen Schicht (1) erzeugt. In wenigstens einem Durchkontaktierungsbereich (9) wird dann ein Platzhaltermaterial aufgebracht. Die Leiteranordnung (2) wird mit einer dielektrischen Flüssigkeit (11) bedeckt, die anschließend zu einer weiteren dielektrischen Schicht (1) ausgehärtet wird. Das Platzhaltermaterial wird anschließend entfernt und der wenigstens eine Durchkontaktierungsbereich (9) mit leitfähigem Material gefüllt. Dann wird mittels des Druckverfahrens eine weitere Leiteranordnung (2) auf der weiteren dielektrischen Schicht (1) erzeugt.

## Beschreibung

Die vorliegende Erfindung betrifft ein Verfahren zum Herstellen einer mehrlagigen Leiterplatte.

Leiterplatten bzw. gedruckte Schaltungen oder engl. "printed circuit boards (PCB)" sind seit Langem bekannt. Sie bestehen aus mindestens einer dielektrischen bzw. isolierenden Schicht, auf der eine Leiteranordnung vorgesehen ist. Die Leiteranordnung umfasst in der Regel Leiterbahnen aus Kupfer. Leiterplatten dienen insbesondere als Träger für elektronische Bauteile und werden daher in einer Vielzahl von elektrischen Geräten verwendet. Um elektrische Schaltungen besonders kompakt anzuordnen, können die Leiterplatten auch mehrlagig, mit mehreren isolierenden Schichten und mehreren Schichten von Leiteranordnungen, ausgebildet sein. Um zwischen den Leiteranordnungen der verschiedenen Schichten elektrische Verbindungen zu schaffen, sind in den isolierenden Schichten sogenannte Durchkontaktierungen vorgesehen. Diese auch "Vias" genannten Durchkontaktierungen sind im einfachsten Fall mit Kupfer gefüllte Bohrungen durch die isolierenden Schichten.

Mehrlagige Leiterplatten können eine Vielzahl von Schichten und entsprechend eine Vielzahl von Durchkontaktierungen aufweisen. In der Serienfertigung werden die Leiterplatten beispielsweise durch photochemische Verfahren hergestellt. Vor einer Serienfertigung ist es in der Regel erforderlich, Prototypen der Leiterplatten zum Testen der Funktionen herzustellen. Hierbei besteht ein Bedarf die Prototypen möglichst schnell, kostengünstig und in hoher Qualität herzustellen.

In jüngerer Zeit wurden Techniken entwickelt, Prototypen von Leiterplatten in sog. 3D-Druckverfahren herzustellen. Eine mehrlagige Leiterplatte wird hierbei insbesondere schichtweise aufgebaut, wobei isolierende Schichten und Leiteranordnungen von unterschiedlichen Druckköpfen eines 3D Druckers auf ein Substrat aufgebracht werden. Sowohl das isolierende Material als auch das leitende Material liegen dabei zunächst als eher zähflüssige Pasten vor. Die Materialien werden schichtweise durch Wärmebehandlung oder Bestrahlung verfestigt. Durchkontaktierungen werden beispielsweise anschließend gebohrt oder mittels Laser in die dielektrischen Schichten eingebracht. Die viskosen Eigenschaften der Materialien beim 3D-Drucken können zu Hohlräumen in den Schichten bzw. zu einer verminderten Schichtqualität führen. Dies kann wiederum die elektrischen Eigenschaften der Leiterplatte bzw. der auf der Leiterplatte angeordneten Bauteile negativ beeinflussen. Darüber hinaus erfordert das Einbringen der Durchkontaktierungen zusätzliche und zeitaufwändige Arbeitsschritte.

Aufgabe der vorliegenden Erfindung ist es, die aus dem Stand der Technik bekannten Nachteile zu beseitigen, insbesondere ein Verfahren bereitzustellen mit dem mehrlagige Leiterplatten bzw. Prototypen von mehrlagigen Leiterplatten schneller und in höherer Qualität hergestellt werden können.

Die Aufgabe wird gelöst durch ein Verfahren mit den Merkmalen des unabhängigen Patentanspruchs.

Vorgeschlagen wird ein Verfahren zum Herstellen einer mehrlagigen Leiterplatte (PCB). Bei dem erfindungsgemäßen Verfahren wird zunächst eine dielektrische Schicht bereitgestellt. Die dielektrische Schicht ist vorzugsweise ein Substrat oder eine dielektrische Schicht einer Leiterplatte, die insbesondere das erfindungsgemäße Verfahren bereits durchlaufen hat. Dielektrisch und isolierend wird im Rahmen der Erfindungsbeschreibung größtenteils gleichbedeutend verwendet. Anschließend wird mittels eines Druckverfahrens eine Leiteranordnung auf der dielektrischen Schicht erzeugt. Insbesondere werden Leiterbahnen aus einem elektrisch leitfähigen Material erzeugt. Das leitfähige Material kann beispielsweise mittels eines Druckkopfes auf die dielektrische Schicht aufgetragen werden.

In wenigstens einem Durchkontaktierungsbereich wird dann ein Platzhaltermaterial aufgebracht. Das Platzhaltermaterial hält den Durchkontaktierungsbereich für das spätere Hinzufügen einer Durchkontaktierung frei. Die Leiteranordnung wird mit einer dielektrischen Flüssigkeit bedeckt, die anschließend zu einer weiteren dielektrischen Schicht ausgehärtet wird. Das Platzhaltermaterial verhindert, dass die dielektrische Flüssigkeit den Durchkontaktierungsbereich oder die Durchkontaktierungsbereiche bedeckt. Durch die dielektrische Flüssigkeit werden alle Bereiche um die Leiteranordnung und über der Leiteranordnung vollständig ausgefüllt. Auf diese Weise entsteht eine kompakte Lage der Leiterplatte ohne Hohlräume. Die dielektrische Flüssigkeit weist hierzu vorzugsweise eine niedrige Viskosität auf.

Das Platzhaltermaterial wird anschließend entfernt und der wenigstens eine Durchkontaktierungsbereich mit leitfähigem Material gefüllt. Hierdurch entsteht die Durchkontaktierung bzw. entstehen die Durchkontaktierungen zu einer weiteren Lage der Leiterplatte. Dann wird mittels des Druckverfahrens eine weitere Leiteranordnung auf der weiteren dielektrischen Schicht erzeugt. Durch die bereits bestehenden Durchkontaktierungen sind die Leiteranordnungen in den verschiedenen Lagen der Leiterplatte elektrisch verbunden. Das Bohren oder Lasern von Löchern für die Durchkontaktierungen kann somit entfallen. Insgesamt erlaubt das Verfahren somit die Herstellung einer mehrlagigen Leiterplatte in kurzer Zeit und mit hoher Qualität.

Es ist vorteilhaft, wenn nach dem Bedecken der Leiteranordnung mit der dielektrischen Flüssigkeit die Leiterplatte in eine kontrollierte Schwenkbewegung versetzt wird, um die dielektrische Flüssigkeit gleichmäßig zu verteilen. Einerseits wird hierdurch sichergestellt, dass sich keine Luftblasen in der dielektrischen Flüssigkeit befinden. Andererseits wird hierdurch zusätzlich sichergestellt, dass die dielektrische Flüssigkeit den Bereich der Leiteranordnung vollständig ausfüllt. Auch wird eine gleichmäßige Schichtdicke der aus der dielektrischen Flüssigkeit entstehenden dielektrischen Schicht gewährleistet. Vorzugsweise wird die Leiterplatte um genau eine Drehachse geschwenkt. Es ist aber ebenfalls denkbar, dass die Leiterplatte um mehrere Drehachsen geschwenkt wird. Beispielsweise kann die Leiterplatte zunächst um eine und anschließend um eine weitere Drehachse geschwenkt werden. Insbesondere liegt die Drehachse bzw. liegen die Drehachsen in einer Ebene der Leiterplatte. Alternativ ist es denkbar, die Leiterplatte in eine Vibration zu versetzen. Die Vibration kann in diesem Fall als Schwenkbewegung mit hoher Geschwindigkeit und sehr kleinem Weg interpretiert werden.

Auch ist es vorteilhaft, wenn die kontrollierte Schwenkbewegung von einer motorisierten kardanischen Aufhängung (Gimbal) ausgeführt wird. Die motorisierte kardanische Aufhängung, die vor allem im Englischen oft Gimbal genannt wird, erlaubt einerseits eine sehr kontrollierte Bewegung der Leiterplatte. Andererseits erlaubt diese Aufhängung eine exakte lotrechte Ausrichtung der Leiterplatte. Beispielsweise kann so die Leiterplatte um eine senkrecht zur Lotrichtung stehende Drehachse geschwenkt werden. Dies trägt wiederum zu einer gleichmäßigen Schichtdicke der aus der dielektrischen Flüssigkeit entstehenden dielektrischen Schicht bei. Eine kardanische Aufhängung weist üblicherweise zwei zueinander rechtwinklig angeordnete Drehlager auf, deren Drehachsen sich schneiden. Bei einem niedrigen Schwerpunkt bleibt das aufgehängte Objekt aufgrund der Schwerkraft damit immer entlang der Lotrichtung ausgerichtet. Bei einer motorisierten kardanischen Aufhängung sind an oder in den Drehlagern Motoren angeordnet, die entweder eine Bewegung der Aufhängung ausgleichen, oder das aufgehängte Objekt kontrolliert bewegen können. Die Drehlager können jeweils einseitig oder beidseitig des gelagerten Objekts ausgebildet sein.

Vorteile bringt es zudem mit sich, wenn das Druckverfahren zum Erzeugen der Leiteranordnungen ein 3D-Druckverfahren ist, insbesondere zum Aufbringen einer leitfähigen Paste. Wie bereits beschrieben, sind 3D-Druckverfahren für das Erzeugen von Leiteranordnungen auf Substraten etabliert. Für das erfindungsgemäße Verfahren kann daher zumindest zum Aufbringen der Leiteranordnungen ein 3D-Drucker nach dem Stand der Technik verwendet werden. Auch ist es denkbar, einen solchen 3D-Drucker für das erfindungsgemäße Verfahren zu erweitern. Beim Erzeugen der Leiteranordnungen wird beispielsweise von einem Druckkopf eine leitfähige Paste in Form von Leiterbahnen auf die dielektrische Schicht aufgetragen. Die Leiterplatte bzw. die dielektrische Schicht mit der Leiteranordnung kann für weitere Verfahrensschritte dann beispielsweise aus dem 3D-Drucker entnommen werden.

Des Weiteren ist es vorteilhaft, wenn als Platzhaltermaterial Silikon und/oder Wachs verwendet wird. Silikon und Wachs sind leicht verfügbare und kostengünstige Materialien, die jeweils nicht mit den für das Verfahren in Frage kommenden dielektrischen Flüssigkeiten binden. Nach dem Aushärten der weiteren dielektrischen Schicht kann das Platzhaltermaterial in einfacher Weise entfernt bzw. entnommen werden. Gegebenenfalls kann das Platzhaltermaterial wiederverwendet werden. Wachs kann aufgrund des niedrigen Schmelzpunkts beispielsweise geschmolzen und in flüssiger Form von der Leiterplatte entfernt werden.

Auch ist es vorteilhaft, wenn die dielektrische Flüssigkeit auf einen Punkt der dielektrischen Schicht mit der Leiteranordnung aufgebracht wird, wobei sich die dielektrische Flüssigkeit durch die Schwerkraft auf der dielektrischen Schicht mit der Leiteranordnung verteilt. Im Gegensatz zu den bekannten Verfahren muss hierbei das Material für die weitere dielektrische Schicht nicht gezielt auf der Leiterplatte platziert werden. Die Durchführung des Verfahrens vereinfacht sich somit. Wie bereits beschrieben, kann zum Fördern der Verteilung der Flüssigkeit auf der dielektrischen Schicht eine Schwenkbewegung der Leiterplatte eingeleitet werden. Die Schwenkbewegung kann ebenfalls zumindest teilweise parallel zum Aufbringen der dielektrischen Flüssigkeit auf die dielektrische Schicht mit der Leiteranordnung durchgeführt werden. Hierdurch ergibt sich eine weitere Zeitersparnis des Verfahrens. Der Punkt auf der dielektrischen Schicht mit der Leiteranordnung kann beispielsweise von einem Applikator für die dielektrische Flüssigkeit einer Vorrichtung zum Durchführen des Verfahrens, vorgegeben sein.

Ebenso bringt es Vorteile mit sich, wenn die Leiteranordnung vor dem Platzieren des Platzhaltermaterials durch eine Wärme- und/oder Lichtbehandlung ausgehärtet wird. Hierdurch wird die Leiteranordnung in Form von permanenten Leiterbahnen fixiert. Auch wird beispielsweise die Leitfähigkeit durch eine Rekristallisation erhöht. Die Wärmebehandlung kann beispielsweise durch eine Temperaturerhöhung durch eine Wärmequelle, insbesondere eine Heizplatte, auf der die Leiterplatte angeordnet ist, stattfinden. Eine Lichtbehandlung kann beispielsweise mittels Bestrahlung durch eine Lichtquelle, insbesondere UV-Licht einer UV-Lichtquelle, stattfinden. Vor dem Aushärten der Leiteranordnung kann insbesondere noch eine Prüfung auf die korrekte Ausbildung der Leiteranordnungen durchgeführt werden. Vor dem Aushärten können bei Bedarf noch Korrekturen an der Leiteranordnung vorgenommen werden.

Vorteile bringt es zudem mit sich, wenn das Platzhaltermaterial mechanisch entfernt, geschmolzen und/oder verdampft wird. Hierdurch werden insbesondere die Maßnahmen, die für ein nasschemisches Verfahren notwendig wären, vermieden. Es ist dennoch denkbar, dass das Platzhaltermaterial alternativ chemisch entfernt wird. Ein mechanisches Entfernen kann beispielsweise mit einer entsprechenden Greifvorrichtung durchgeführt werden. Dies eignet sich vor allem für das bereits erwähnte Silikon. Auch ist es denkbar, das Platzhaltermaterial mittels einer Unterdruckquelle abzusaugen. Aufgrund des niedrigen Schmelzpunkts kann insbesondere Wachs geschmolzen und/oder verdampft werden. Zum einen kann das Platzhaltermaterial zunächst geschmolzen und dann in flüssiger Form entfernt werden. Mit einem direkten Verdampfen des Platzhaltermaterials kann eine zusätzliche mechanische Einwirkung auf die Leiterplatte oder das Platzhaltermaterial vermieden werden. Ein Schmelzen und/oder Verdampfen des Platzhaltermaterials kann beispielsweise durch die bereits beschriebene Wärmequelle bewirkt werden.

Vorteilhaft ist es zudem, wenn die dielektrische Schicht in einem Behälter bereitgestellt wird, der aus einem die dielektrische Flüssigkeit abweisenden Material hergestellt ist oder mit diesem Material beschichtet ist. Hierdurch wird ein Verbinden der dielektrischen Flüssigkeit mit dem Behälter vermieden. Außerdem wird durch den Behälter ein Auslaufen der dielektrischen Flüssigkeit vermieden. Eine Länge und eine Breite des Behälters entsprechen insbesondere einer Länge und Breite der herzustellenden Leiterplatte. Der Behälter kann beispielsweise aus Silikon hergestellt sein. Auch kann der Behälter mit Wachs bzw. Wachspapier beschichtet sein. Ein aus Wachspapier hergestellter Behälter ist ebenfalls denkbar. Ein elastischer Behälter kann das Entfernen der Leiterplatte nach dem Herstellungsverfahren erleichtern. Ebenfalls ist es denkbar, dass der Behälter nach dem Verfahren bei einer Entnahme der Leiterplatte zerstört wird. Der Behälter kann beispielsweise ebenfalls in einem 3D-Druckverfahren hergestellt sein.

Des Weiteren ist es vorteilhaft, wenn als dielektrische Flüssigkeit Epoxidharz verwendet wird. Epoxidharz hat in der flüssigen Form die notwendigen Eigenschaften für die dielektrische Flüssigkeit des erfindungsgemäßen Verfahrens. Es lässt sich relativ leicht handhaben und härtet nach dem Vermischen mit einem Härter in der Regel zu einer gleichmäßigen und stabilen isolierenden Schicht aus. Bestimmte Formen von Epoxidharz können beispielsweise sehr schnell durch die Bestrahlung mit UV-Licht ausgehärtet werden. Andererseits findet eine Aushärtung in der Regel auch ohne Bestrahlung dafür aber langsamer statt. Ein Aushärten des Epoxidharzes kann mit der bereits beschriebenen UV-Lichtquelle und/oder Wärmequelle beschleunigt werden. Vorzugsweise weist das verwendete Epoxidharz in der flüssigen Form eine niedrige Viskosität auf.

Eine Vorrichtung zum Herstellen einer mehrlagigen Leiterplatte (PCB) nach dem zuvor beschriebenen Verfahren, wobei die Merkmale des Verfahrens einzeln oder in beliebiger Kombination vorliegen können, umfasst einen Behälter für die dielektrische Schicht und einen ersten Druckkopf zum Erzeugen der Leiteranordnung auf der dielektrischen Schicht. Die Vorrichtung umfasst außerdem eine motorisierte kardanische Aufhängung (Gimbal), auf der der Behälter angeordnet ist. Wie zuvor beschrieben, kann die kardanische Aufhängung den Behälter einerseits genau lotrecht ausrichten. Andererseits kann der Behälter in eine genau kontrollierte Schwenkbewegung versetzt werden, die insbesondere zu einer gleichmäßigen Verteilung der dielektrischen Flüssigkeit beiträgt.

Vorzugsweise ist der erste Druckkopf in einer oder mehreren Ebenen translatorisch verfahrbar. Der erste Druckkopf kann eine Heizvorrichtung für das Heizen des zu druckenden Materials aufweisen. Der Behälter ist vorzugsweise zumindest in Bezug auf eine Translationsbewegung stationär, also unbeweglich angeordnet. Neben der motorisierten kardanischen Aufhängung entfällt damit eine zusätzliche xy-Motorisierung.

Eine kardanische Aufhängung weist üblicherweise zwei zueinander rechtwinklig angeordnete Drehlager auf, deren Drehachsen sich schneiden. Bei einem niedrigen Schwerpunkt bleibt das aufgehängte Objekt aufgrund der Schwerkraft damit immer entlang der Lotrichtung ausgerichtet. Bei einer motorisierten kardanischen Aufhängung sind an oder in den Drehlagern Motoren angeordnet, die entweder eine Bewegung der Aufhängung ausgleichen, oder das aufgehängte Objekt kontrolliert bewegen können. Die Drehlager können jeweils einseitig oder beidseitig des gelagerten Objekts ausgebildet sein. Die motorisierte kardanische Aufhängung kann einen Sensor oder mehrere Sensoren zum Erfassen der räumlichen Lage des aufgehängten Objekts, vorliegend des Behälters, aufweisen.

Auch ist es vorteilhaft, wenn die Vorrichtung einen stationären Applikator für die dielektrische Flüssigkeit aufweist. Das erfindungsgemäße Verfahren erlaubt ein Aufbringen der dielektrischen Flüssigkeit an einem beliebigen Punkt der Leiterplatte. Deshalb kann der Applikator unbeweglich und damit kostengünstiger ausgebildet sein. Der Applikator weist insbesondere eine auf den Behälter gerichtete Tülle zum Aufbringen der dielektrischen Flüssigkeit auf. Die Tülle kann wechselbar als Verbrauchsmaterial ausgebildet sein. Außerdem kann der Applikator mit einer Pumpe und eventuell mit einem Reservoir für die dielektrische Flüssigkeit verbunden sein. Der Applikator kann einen Mischer, insbesondere zum Mischen von Epoxidharz und einem entsprechenden Härter, aufweisen.

Vorteilhaft ist es zudem, wenn die Vorrichtung einen zweiten Druckkopf zum Aufbringen des Platzhaltermaterials aufweist. Hierdurch kann das Platzhaltermaterial automatisiert aufgetragen werden. Der zweite Druckkopf kann ähnlich oder gleich dem ersten Druckkopf ausgebildet sein. Es ist prinzipiell möglich, dass der erste Druckkopf sowohl für das Aufbringen der Leiteranordnung als auch des Platzhaltermaterials verwendet wird. Allerdings ist dann gegebenenfalls eine Reinigung des ersten Druckkopfes zwischen den Verfahrensschritten notwendig. Der zweite Druckkopf ist vorzugsweise in einer oder mehreren Ebenen translatorisch verfahrbar. Der zweite Druckkopf kann ebenfalls eine Heizvorrichtung für das Heizen des Platzhaltermaterials aufweisen.

Vorteile bringt es mit sich, wenn der Behälter aus einem die dielektrische Flüssigkeit abweisenden Material hergestellt ist oder mit diesem Material beschichtet ist. Hierdurch wird eine Verbindung zwischen der dielektrischen Flüssigkeit und dem Behälter vermieden. Außerdem kann die dielektrische Flüssigkeit nicht auslaufen. Wie bereits beschrieben, entsprechen eine Länge und eine Breite des Behälters insbesondere einer Länge und Breite der herzustellenden Leiterplatte. Der Behälter kann beispielsweise aus Silikon hergestellt sein. Auch kann der Behälter mit Wachs bzw. Wachspapier beschichtet sein. Ein aus Wachspapier hergestellter Behälter ist ebenfalls denkbar. Ein elastischer Behälter kann das Entfernen der Leiterplatte nach dem Herstellungsverfahren erleichtern. Ebenfalls ist es denkbar, dass der Behälter nach dem Verfahren bei einer Entnahme der Leiterplatte zerstört wird. Der Behälter kann beispielsweise ebenfalls in einem 3D-Druckverfahren hergestellt sein.

Vorteilhaft ist es außerdem, wenn die Vorrichtung eine Lichtquelle und/oder eine Wärmequelle aufweist. Durch eine Licht- und/oder Wärmebehandlung können insbesondere die Leiteranordnung und/oder die dielektrische Flüssigkeit ausgehärtet werden. Die Wärmequelle kann insbesondere als Heizplatte ausgebildet sein. Der Behälter kann beispielsweise auf der Wärmequelle angeordnet sein. Die Lichtquelle kann insbesondere als UV-Lichtquelle ausgebildet sein. Insbesondere ist der Behälter unterhalb der Lichtquelle ageordnet.

Weitere Vorteile der Erfindung sind in den nachfolgenden Ausführungsbeispielen beschrieben. Es zeigt:
- **Figur 1**: eine schematische Darstellung eines ersten Verfahrensschritts des erfindungsgemäßen Verfahrens,
- **Figur 2**: eine schematische Darstellung eines zweiten Verfahrensschritts des erfindungsgemäßen Verfahrens,
- **Figur 3**: eine schematische Darstellung eines dritten Verfahrensschritts des erfindungsgemäßen Verfahrens,
- **Figur 4**: eine schematische Darstellung eines vierten Verfahrensschritts des erfindungsgemäßen Verfahrens,
- **Figur 5**: eine schematische Darstellung eines fünften Verfahrensschritts des erfindungsgemäßen Verfahrens,
- **Figur 6**: eine schematische Darstellung eines sechsten Verfahrensschritts des erfindungsgemäßen Verfahrens,
- **Figur 7**: eine schematische Darstellung eines siebten Verfahrensschritts des erfindungsgemäßen Verfahrens,
- **Figur 8**: eine schematische Darstellung eines achten Verfahrensschritts des erfindungsgemäßen Verfahrens, und
- **Figur 9**: eine schematische Draufsicht auf eine dielektrische Schicht mit einer Leiteranordnung.

Bei der nachfolgenden Beschreibung der Figuren werden für in den verschiedenen Figuren jeweils identische und/oder zumindest vergleichbare Merkmale gleiche Bezugszeichen verwendet. Die einzelnen Merkmale, deren Ausgestaltung und/oder Wirkweise werden meist nur bei ihrer ersten Erwähnung ausführlich erläutert. Werden einzelne Merkmale nicht nochmals detailliert erläutert, so entspricht deren Ausgestaltung und/oder Wirkweise der Ausgestaltung und Wirkweise der bereits beschriebenen gleichwirkenden oder gleichnamigen Merkmale.

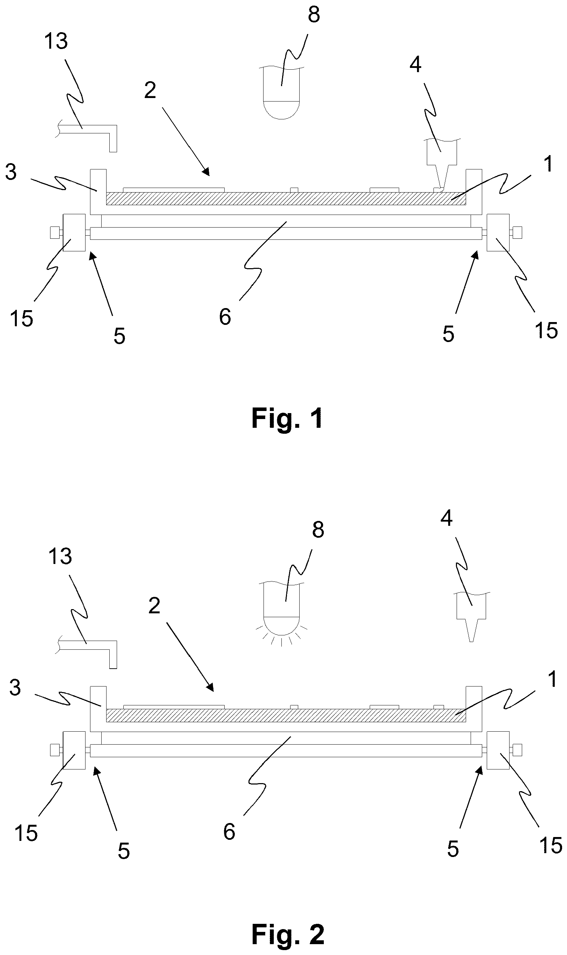

Figur 1 zeigt eine schematische Darstellung eines ersten Verfahrensschritts des erfindungsgemäßen Verfahrens. Nach dem Bereitstellen einer dielektrischen Schicht 1 wird auf der Schicht 1 mittels eines Druckverfahrens eine Leiteranordnung 2 erzeugt. Die dielektrische Schicht 1 ist hierzu beispielsweise in einem Behälter 3 angeordnet. Insbesondere wird zum Erzeugen der Leiteranordnung 2 von einem ersten Druckkopf 4 eine elektrisch leitende Paste auf die elektrische Schicht 1 aufgetragen. Der Behälter 3 ist in diesem Beispiel auf einer motorisierten kardanischen Aufhängung 5 angeordnet, die in dieser Darstellung nur angedeutet ist. Ebenfalls kann unter dem Behälter 3 eine Wärmequelle 6, insbesondere in Form einer Heizplatte, angeordnet sein.

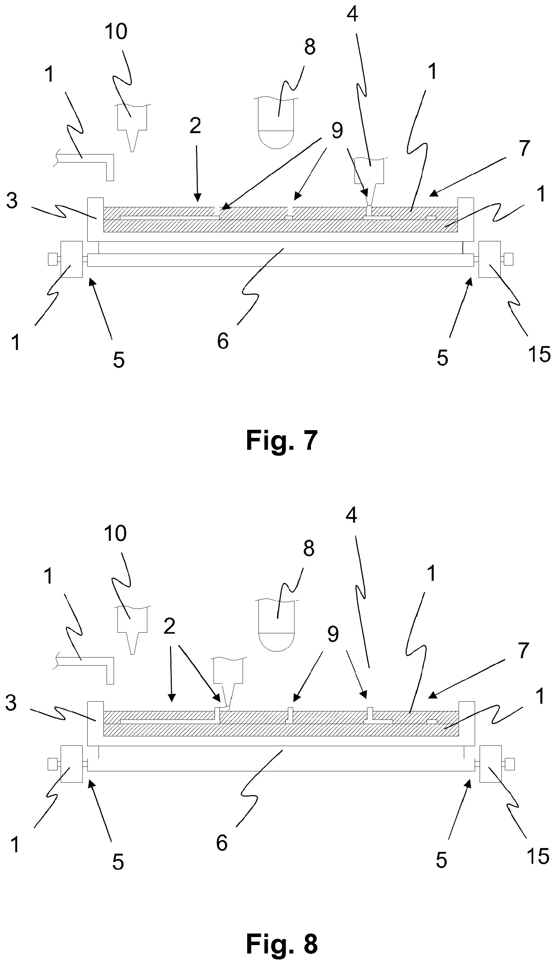

Eine Breite des Behälters 3 entspricht einer Breite der dielektrischen Schicht 1 bzw. einer Breite der herzustellenden Leiterplatte 7 (siehe Figur 8). Neben einer Beweglichkeit durch die kardanische Aufhängung 5 ist der Behälter 3 vorzugsweise unbeweglich angeordnet. Zum Auftragen der Leiteranordnung 2, ist der erste Druckkopf 4 vorzugsweise in wenigstens einer Ebene bewegbar. Im vorliegenden Beispiel ist der erste Druckkopf 4 in zwei Ebenen bewegbar. Einerseits kann der erste Druckkopf 4 parallel zur Oberfläche der dielektrischen Schicht 1 bewegt werden. Andererseits kann der Abstand zwischen dem ersten Druckkopf und der dielektrischen Schicht 1 vergrößert und verringert werden. Die dielektrische Schicht 1 ist in diesem Fall ein isolierendes Substrat. Es ist aber ebenfalls denkbar, dass die dielektrische Schicht 1 bereits Bestandteil einer Leiterplatte 7 ist, die insbesondere bereits das erfindungsgemäße Verfahren durchlaufen hat.

Figur 2 zeigt eine Aushärtung der Leiteranordnung 2. Hierzu wird die Leiteranordnung 2 beispielsweise mit Licht einer Lichtquelle 8 bestrahlt. Die Lichtquelle 8 ist insbesondere als UV-Lichtquelle ausgebildet. Alternativ oder ergänzend kann die dielektrische Schicht 1 und damit die Leiteranordnung 2 ebenfalls mittels der Wärmequelle 6 erwärmt werden. Die Leiteranordnung 2 wird in diesem Schritt fixiert. Eine Beschädigung der Leiteranordnung 2 insbesondere im Verlauf der weiteren Verfahrensschritte wird dadurch unwahrscheinlicher. Auch kann eine Leitfähigkeit der Leiteranordnung 2 durch Bestrahlen und/oder Erwärmen insbesondere durch eine Rekristallisation verbessert werden. Der erste Druckkopf 4 kann in diesem Schritt beispielsweise in einer Warteposition verweilen.

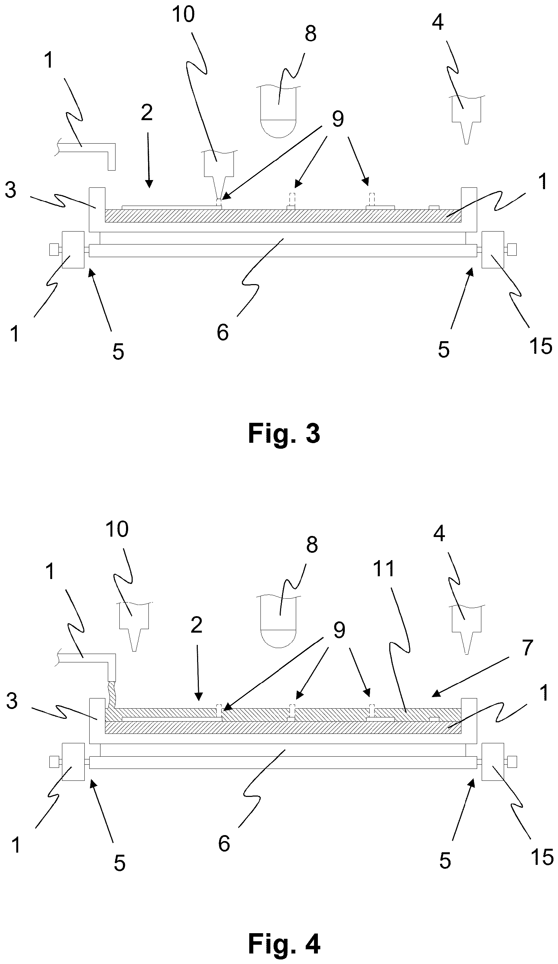

Figur 3 zeigt das Aufbringen eines Platzhaltermaterials in wenigstens einem bzw. in diesem Beispiel in mehreren Durchkontaktierungsbereichen 9. Das Platzhaltermaterial in den Durchkontaktierungsbereichen 9 ist durch gestrichelte Linien dargestellt. In den Durchkontaktierungsbereichen 9 wird ein Kontakt zwischen Leiteranordnungen 2 verschiedener Lagen der mehrlagigen Leiterplatte 7 hergestellt. Das Platzhaltermaterial kann beispielsweise von einem zweiten Druckkopf 10 aufgetragen werden. Der zweite Druckkopf 10 kann ähnlich oder gleich dem ersten Druckkopf 4 ausgebildet sein. Als Platzhaltermaterial kommen insbesondere Silikon oder Wachs in Frage. Das Platzhaltermaterial kann selbstverständlich auch mit einer anderen Methode aufgebracht werden. Insbesondere ist es denkbar, dass das Platzhaltermaterial von einem Menschen manuell aufgetragen wird. Eventuell kann das Platzhaltermaterial analog der Leiteranordnung oder durch bloßes Abwarten ausgehärtet werden.

Figur 4 zeigt ein Bedecken der Leiteranordnung 2 mit einer dielektrischen Flüssigkeit 11. Das Platzhaltermaterial hält hierbei die Durchkontaktierungsbereiche 9 von der dielektrischen Flüssigkeit 11 frei. Hierzu sollte das Platzhaltermaterial möglichst ein Material sein, dass die dielektrische Flüssigkeit 11 abweist oder sich zumindest nicht mit der dielektrischen Flüssigkeit 11 verbindet. Ebenso kann der Behälter 3 aus einem Material hergestellt sein oder mit einem Material beschichtet sein, das die dielektrische Flüssigkeit 11 abweist. Die dielektrische Flüssigkeit 11 wird auf genau einen Punkt 12 der dielektrischen Schicht 1 mit der Leiteranordnung 2 aufgebracht und verteilt sich dort zumindest teilweise durch die Schwerkraft. Hierdurch wird die dielektrische Flüssigkeit 11 schnell und einfach aufgebracht. Die dielektrische Flüssigkeit 11 kann beispielsweise von einem stationären, also unbeweglichen Applikator 13 auf die dielektrische Schicht 1 mit der Leiteranordnung 2 aufgebracht werden.

Eine Menge der dielektrischen Flüssigkeit 11 richtet sich nach der gewünschten Schichtdicke. Während dieses Verfahrensschrittes können der erste Druckkopf 4 und/oder der zweite Druckkopf 10 beispielsweise in einer Warteposition verweilen. Am Ende dieses Verfahrensschrittes sollte die Leiteranordnung 2 möglichst von der dielektrischen Flüssigkeit 11 bedeckt sein. Die dielektrische Flüssigkeit 11 kann beispielsweise Epoxidharz in seiner flüssigen Form, aber insbesondere bereits in einer Mischung mit einem Härter, sein.

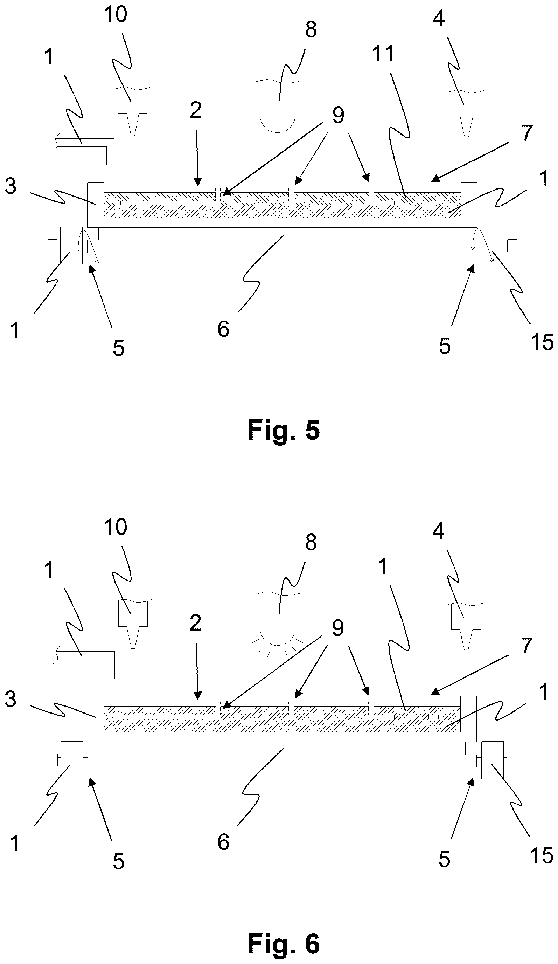

In Figur 5 ist durch die Pfeile eine kontrollierte Schwenkbewegung des Behälters 3 bzw. der Leiterplatte 7 angedeutet. Hierdurch kann eine gleichmäßige Verteilung der dielektrischen Flüssigkeit 11 sichergestellt werden. Außerdem werden hierdurch eventuell in der dielektrischen Flüssigkeit 11 vorhandene Lufteinschlüsse bzw. Blasen ausgeleitet. Die Schwenkbewegung kann insbesondere von Motoren der motorisierten kardanischen Aufhängung 5 ausgeführt werden. Insbesondere befindet sich die Drehachse, um die geschwenkt wird, in einer Ebene der Leiterplatte 7 oder die Drehachse ist beispielsweise parallel zu einer Ebene der Leiterplatte 7. Die Drehachse kann senkrecht zu einer Lotrichtung stehen. Auch ist es denkbar, dass parallel oder sequentiell um mehrere Drehachsen geschwenkt wird. Die Drehachsen entsprechen hierbei beispielsweise denjenigen der Drehlager der motorisierten kardanischen Aufhängung 5.

Figur 6 zeigt eine Aushärtung der dielektrischen Flüssigkeit 11 zu einer weiteren dielektrischen Schicht 1. In diesem Beispiel wird die Aushärtung durch eine Bestrahlung durch die Lichtquelle 8 beschleunigt. Zusätzlich oder alternativ kann die Aushärtung auch durch ein Erwärmen durch die Wärmequelle 6 unterstützt werden. Es ist ebenfalls denkbar, dass ein Aushärten ohne Unterstützung durch einfaches Abwarten stattfindet. Nach diesem Verfahrensschritt kann das Platzhaltermaterial entfernt werden. Hierdurch ergeben sich in den Durchkontaktierungsbereichen 9 Lücken in der weiteren dielektrischen Schicht 1. Das Entfernen des Platzhaltermaterials kann beispielsweise mechanisch, durch Schmelzen und/oder Verdampfen erfolgen.

Figur 7 zeigt die Leiterplatte 7 mit bereits entferntem Platzhaltermaterial. In diesem Verfahrensschritt werden die Durchkontaktierungsbereiche 9 mit elektrisch leitendem Material ausgefüllt. Die Ausfüllung der Durchkontaktierungsbereiche 9 kann beispielsweise von dem ersten Druckkopf 4 und insbesondere mit dem gleichen Material, das für die Leiteranordnung 2 verwendet wird, durchgeführt werden. Es ist denkbar, dass das Material in den Durchkontaktierungsbereichen 9 anschließend analog zu der Leiteranordnung 2 ausgehärtet wird. Die entstehenden Durchkontaktierungen bzw. Vias verbinden die Leiteranordnungen 2 verschiedener Lagen der Leiterplatte 7 miteinander.

Falls eine oder mehrere der Durchkontaktierungen bei einer weiteren Durchführung des Verfahrens komplett von der dielektrischen Flüssigkeit 11 überdeckt wird, wobei insbesondere in diesem Fall kein Platzhaltermaterial im Bereich der Durchkontaktierung vorgesehen wird, entstehen "vergrabene" Durchkontaktierungen bzw. "Buried Vias".

Figur 8 zeigt die Leiterplatte 7 mit den entstandenen Durchkontaktierungen in den Durchkontaktierungsbereichen 9. In diesem Verfahrensschritt wird eine weitere Leiteranordnung 2 auf der weiteren dielektrischen Schicht 1 durch das Druckverfahren erzeugt. Durch die Durchkontaktierungen in den Durchkontaktierungsbereichen 9 sind die Leiteranordnungen 2 der verschiedenen Lagen der Leiterplatte 7 elektrisch verbunden. Die weitere Leiteranordnung 2 kann wieder in Form einer elektrisch leitenden Paste von dem ersten Drucckopf 4 auf die weitere dielektrische Schicht 1 aufgebracht werden. Dieser letzte Verfahrensschritt kann gleichzeitig der erste Schritt einer erneuten Durchführung des erfindungsgemäßen Verfahrens sein.

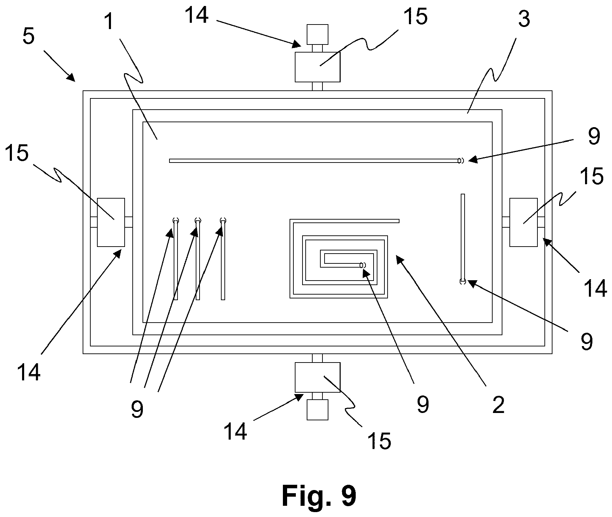

Figur 9 zeigt eine schematische Draufsicht auf eine dielektrische Schicht 1 mit einer Leiteranordnung 2 in einem Behälter 3. Diese Ansicht dient der Verdeutlichung der motorisierten kardanischen Aufhängung 5, auf der der Behälter 3 angeordnet ist. Der Behälter 3 ist um zwei sich schneidende und rechtwinklig zueinander angeordnete Drehachsen schwenkbar. Die kardanische Aufhängung 5 weist hierzu jeweils beidseitig des Behälters 3 Drehlager 14 auf. An den Drehlagern 14 sind Motoren 15 angeordnet, die einerseits ungewollte Bewegungen des Behälters 3, insbesondere während des Druckverfahrens zur Erzeugung der Leiteranordnungen 2, ausgleichen können. Andererseits können die Motoren 15 den Behälter 3 in kontrollierte Schwenkbewegungen versetzen. Außerhalb kontrollierter Schwenkbewegungen halten die Motoren 15 den Behälter 3 vorzugsweise senkrecht zur Lotrichtung.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: dielektrische Schicht
- 2: Leiteranordnung
- 3: Behälter
- 4: erster Druckkopf
- 5: motorisierte kardanische Aufhängung
- 6: Wärmequelle
- 7: Leiterplatte
- 8: Lichtquelle
- 9: Durchkontaktierungsbereich
- 10: zweiten Druckkopf
- 11: dielektrische Flüssigkeit
- 12: Punkt
- 13: Applikator
- 14: Drehlager
- 15: Motor

## Patentansprüche

1. Verfahren zum Herstellen einer mehrlagigen Leiterplatte (PCB) (7) mit den Schritten:
- Bereitstellen einer dielektrischen Schicht (1),
- Erzeugen einer Leiteranordnung (2) auf der dielektrischen Schicht (1) mittels eines Druckverfahrens,
- Aufbringen eines Platzhaltermaterials in wenigstens einem Durchkontaktierungsbereich (9),
- Bedecken der Leiteranordnung (2) mit einer dielektrischen Flüssigkeit (11),
- Aushärten der dielektrischen Flüssigkeit (11) zu einer weiteren dielektrischen Schicht (1),
- Entfernen des Platzhaltermaterials,
- Füllen des wenigstens einen Durchkontaktierungsbereichs (9) mit leitfähigem Material, und
- Erzeugen einer weiteren Leiteranordnung (2) auf der weiteren dielektrischen Schicht (1) mittels des Druckverfahrens.

2. Verfahren nach dem vorherigen Anspruch, **dadurch gekennzeichnet, dass** nach dem Bedecken der Leiteranordnung (2) mit der dielektrischen Flüssigkeit (11) die Leiterplatte (7) in eine kontrollierte Schwenkbewegung versetzt wird, um die dielektrische Flüssigkeit (11) gleichmäßig zu verteilen.

3. Verfahren nach dem vorherigen Anspruch, **dadurch gekennzeichnet, dass** die kontrollierte Schwenkbewegung von einer motorisierten kardanischen Aufhängung (Gimbal) (5) ausgeführt wird.

4. Verfahren nach einem der vorherigen Ansprüche, **dadurch gekennzeichnet, dass** das Druckverfahren zum Erzeugen der Leiteranordnungen (2) ein 3D-Druckverfahren ist, insbesondere zum Aufbringen einer leitfähigen Paste.

5. Verfahren nach einem der vorherigen Ansprüche, **dadurch gekennzeichnet, dass** als Platzhaltermaterial Silikon und/oder Wachs verwendet wird.

6. Verfahren nach einem der vorherigen Ansprüche, **dadurch gekennzeichnet, dass** die dielektrische Flüssigkeit (11) auf einen Punkt (12) der dielektrischen Schicht (1) mit der Leiteranordnung (2) aufgebracht wird, wobei sich die dielektrische Flüssigkeit (11) durch die Schwerkraft auf der dielektrischen Schicht (1) mit der Leiteranordnung (2) verteilt.

7. Verfahren nach einem der vorherigen Ansprüche, **dadurch gekennzeichnet, dass** die Leiteranordnung (2) vor dem Platzieren des Platzhaltermaterials durch eine Wärme- und/oder Lichtbehandlung ausgehärtet wird.

8. Verfahren nach einem der vorherigen Ansprüche, **dadurch gekennzeichnet, dass** das Platzhaltermaterial mechanisch entfernt, geschmolzen und/oder verdampft wird.

9. Verfahren nach einem der vorherigen Ansprüche, **dadurch gekennzeichnet, dass** die dielektrische Schicht (1) in einem Behälter (3) bereitgestellt wird, der aus einem die dielektrische Flüssigkeit (11) abweisenden Material hergestellt ist oder mit diesem Material beschichtet ist.

10. Verfahren nach einem der vorherigen Ansprüche, **dadurch gekennzeichnet, dass** als dielektrische Flüssigkeit (11) Epoxidharz verwendet wird.

11. Vorrichtung zum Herstellen einer mehrlagigen Leiterplatte (PCB) (7) nach einem Verfahren eines oder mehrerer der vorherigen Ansprüche, mit
- einem Behälter (3) für die dielektrische Schicht (1) und
- einem ersten Druckkopf (4) zum Erzeugen der Leiteranordnung (2), **gekennzeichnet durch**
eine motorisierte kardanische Aufhängung (Gimbal) (5), auf der der Behälter (3) angeordnet ist.

12. Vorrichtung nach dem vorherigen Anspruch, **gekennzeichnet durch** einen stationären Applikator (13) für die dielektrische Flüssigkeit (11).

13. Vorrichtung nach einem der Ansprüche 11 oder 12, **gekennzeichnet durch** einen zweiten Druckkopf (10) zum Aufbringen des Platzhaltermaterials.

14. Vorrichtung nach einem der Ansprüche 11 bis 13, **dadurch gekennzeichnet, dass** der Behälter (3) aus einem die dielektrische Flüssigkeit (11) abweisenden Material hergestellt ist oder mit diesem Material beschichtet ist.

15. Vorrichtung nach einem der Ansprüche 11 bis 14, **gekennzeichnet durch** eine Lichtquelle (8) und/oder eine Wärmequelle (6).
